**Europäisches Patentamt**

**European Patent Office**

**Office européen des brevets**

(19)

(11) Veröffentlichungsnummer : **0 258 341 B1**

(12) **EUROPÄISCHE PATENTSCHRIFT**

(45) Veröffentlichungstag der Patentschrift :
13.03.91 Patentblatt 91/11

(51) Int. Cl.⁵ : **H04N 7/137, H04N 7/133**

(21) Anmeldenummer : **87901426.4**

(22) Anmeldetag : **07.02.87**

(86) Internationale Anmeldenummer :
**PCT/EP87/00060**

(87) Internationale Veröffentlichungsnummer :
**WO 87/05178 27.08.87 Gazette 87/19**

(54) **VERFAHREN ZUR DIGITALEN NACHRICHTENÜBERTRAGUNG.**

(30) Priorität : **18.02.86 DE 3605032**

(43) Veröffentlichungstag der Anmeldung :
**09.03.88 Patentblatt 88/10**

(45) Bekanntmachung des Hinweises auf die
Patenterteilung :
**13.03.91 Patentblatt 91/11**

(84) Benannte Vertragsstaaten :
**AT BE CH DE FR GB IT LI LU NL SE**

(56) Entgegenhaltungen :
**US-A- 4 292 651**
**US-A- 4 394 774**
**Conference Record on the International Conference on Communications, 14-18 June 1981, Denver, Colorado, volume 2 W.Chen: "Scene adaptive coder", pages 22.5.1 to 22.5.6 see pages 22.5.3, left hand column, line 28 - right hand column, line 27**

(56) Entgegenhaltungen :
**Conference Record on the National Telecommunications Conference, NTC 1980, 30 November to 4 December 1980, Houston, Texas, volume 2 I. Dukhovich: " A DPCM system based on a composite image model "; pages 36.2.1 to 36.2.6 see page 36.2.3, left hand column, line 1 - page 36.2.4, left hand column, line 6**

(73) Patentinhaber : **Deutsche Thomson-Brandt GmbH**
**Hermann-Schwer-Strasse 3 Postfach 1307**
**W-7730 Villingen-Schwenningen (DE)**

(72) Erfinder : **KEESEN, Heinz-Werner**
**Tiestestr. 5**
**W-3000 Hannover 1 (DE)**
Erfinder : **PETERS, Hartmut**
**Tiestestr. 34**
**W-3000 Hannover 1 (DE)**

(74) Vertreter : **Einsel, Robert, Dipl.-Ing.**
**Deutsche Thomson-Brandt GmbH Patent- und Lizenzabteilung Göttinger Chaussee 76**
**W-3000 Hannover 91 (DE)**

## Beschreibung

Die Erfindung betrifft ein Verfahren zur digitalen Nachrichtenübertragung gemäß dem Oberbegriff des Patentanspruchs 1.

Aus der EP-A-0 084 270 ist ein Verfahren zur Verschlüsselung von transformierten Koeffizienten bekannt. Eine Mehrzahl von Code Tabellen wird dazu benutzt, einen Block Adressen Code, einen DC-Koeffizienten Code und eine Folge von Codes für transformierte Koeffizienten zu generieren. Code wird im folgenden Kode genannt.

Ein aus der Veröffentlichung von Dukhovich, I.J. "A DPCM System Based on a Composite Image Model", Conference Record on the National Televommunications Conference, NTC 1980, Band 2 bekanntes Verfahren bedient sich ebenfalls Kode-Tabellen.

Solche Kode-Tabellen besitzen den Nachteil, daß sie die tatsächliche Verteilung der Häufigkeit der Daten nur näherungsweise berücksichtigen können und so der theoretisch günstigste Kode nicht oder nur selten angewendet werden kann. Zwar ließen sich die Kode-Tabellen so verfeinern, daß alle praktisch auftretenden Variationen erfaßt werden können, diese Maßnahme hätte aber einen extrem großen Speicherbedarf, verbunden mit längeren Zugriffszeiten auf den jeweils günstigsten Kode zur Folge.

Ausgehend von diesem Stand der Technik liegt der Erfindung die Aufgabe zugrunde, bei geringem Speicherbedarf das eingangs genannte Übertragungsverfahren weiter zu verbessern und/oder den Informationsgehalt eines Signals bzw. einer Information zu optimieren.

Diese Aufgabe wird durch die im Patentanspruch 1 genannten Merkmale gelöst. Vorteilhafte Weiterbildungen sind in Unteransprüchen genannt.

Es zeigen
Fig. 1 ein Übertragungssystem
Fig. 2 einen Quellenkoder
Fig. 3 einen Koeffizienten Block
Fig. 4 eine Tabelle
Fig. 5 eine Huffman-Kodierung
Fig. 6 einen Zick-Zack-Scan
Fig. 7 einen Koeffizienten Block mit Zick-Zack-Scan-Abtastung
Fig. 8 Übertragungsmengen
Fig. 9 einen Bildschirm
Fig. 10 einen Sender
Fig. 11 einen Empfänger
Fig. 12 einen Huffman-Koder
Fig. 13 einen Huffman-Dekoder.

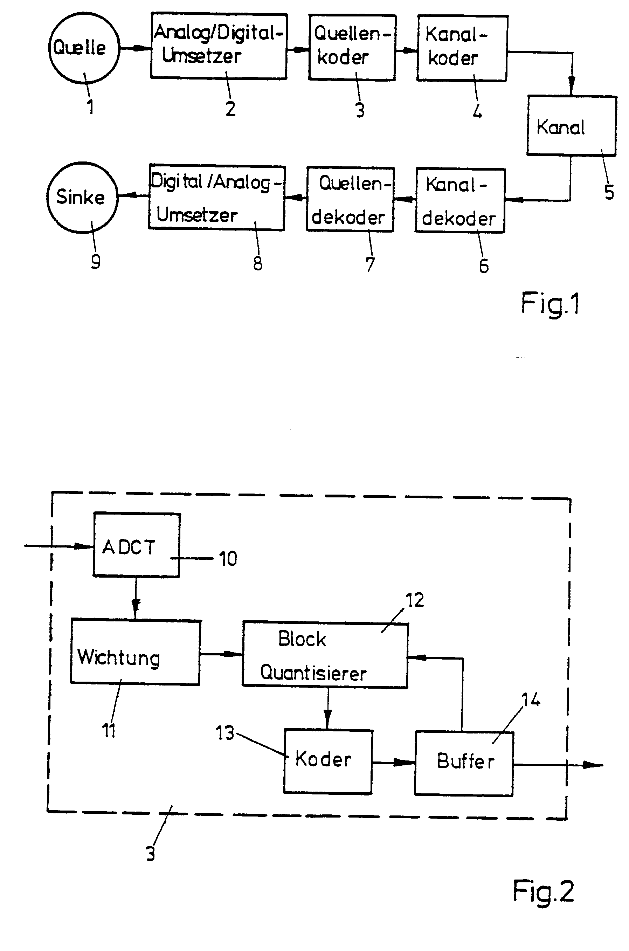

Fig. 1 zeigt eine Nachrichtenquelle 1, einen ADU 2 (Analog-Digital-Umsetzer), einen Quellenkoder 3, einen Kanalkoder 4, einen Kanal 5, einen Kanaldekoder 6, einen Quellendekoder 7, einen DAU 8 (Digital-Analog-Umsetzer) und eine Nachrichtensinke 9. Der Kanal 5 kann beispielsweise für eine HF-Übertragungsstrecke oder einen digitalen Videorecorder stehen. Ein digitaler Videorecorder kann aber auch beispielsweise für den ADU 2, den Quellenkoder 3, den Kanalkoder 4, den Kanal 5, den Kanaldekoder 6, den Quellendekoder 7 und den DAU 8 stehen. Die Quelle wird dann durch eine HF-Übertragungsstrecke, der Kanal 5 durch ein Magnetband und einen Magnetkopf des Videorecorders gebildet, die Sinke ist ein Fernsehgerät.

Fig. 2 zeigt, daß ein Digitalsignal erstens einen ADCT 10 (Adaptiven-Diskreten-Cosinus-Transformator), zweitens eine Wichtung 11, drittens einen Blockquantisierer 12, viertens einen Koder 13 und fünftens einen Buffer 14 durchläuft. Speziell wenn Bilder direkt ohne Zwischenspeicherung an einen Quellenkoder 7 abgegeben werden, muß der Blockquantisierer 11 so gesteuert sein, daß empfängerseitig immer genügend Daten für die Erzeugung eines Bildes mit akzeptabler Bildqualität vorhanden ist.

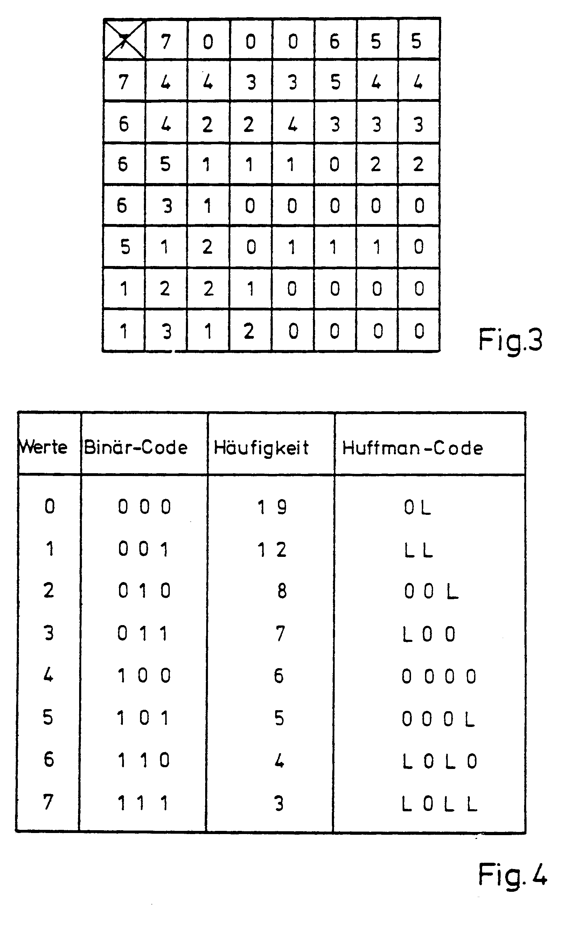

Fig. 3 zeigt einen Block von Spektralwerten, wie er nach einer adaptiven diskreten Cosinus Transformation an dem Block-Quantisierer 11 ansteht. Die mit X markierte Stelle beinhaltet den Spektralwert für den Gleichanteil einer Matrix, im folgenden Mittelwert genannt. In der Praxis wird z.Zt. mit einer $8 \times 8$ Matrix gearbeitet, das entspricht 64 Spektralwerten bzw. 64 Bildpunkten pro Block. Der $8 \times 8$ Block enthält 64 Spektralwerte oder Spektralkoeffizienten 0, 1, 2,..., 7, im folgenden Werte genannnt.

Fig. 4 zeigt eine Tabelle zu den Werten 0, 1, 2,..., 7. Die acht Werte können in Binärkode mit Hilfe von drei Binärzeichen pro Wert dargestellt werden. Nach Huffman können bei einer Übertragung Binärzeichen eingespart werden. Dabei wird die Häufigkeit der zu übertragenden Werte festgestellt und das am häufigsten üertragene Element mit weniger Binärzeichen versehen als das am wenigsten zu übertragende Element. Der Wert 0 tritt in dem $8 \times 8$ Block neunzehnmal, der Wert 1 zwölfmal, der Wert 2 achtmal usw. auf. Für den Wert 0 wird nach Huffman der Kode 01, für den Wert 1 der Kode 11 und für den Wert 7 der Kode 1011 übertragen.

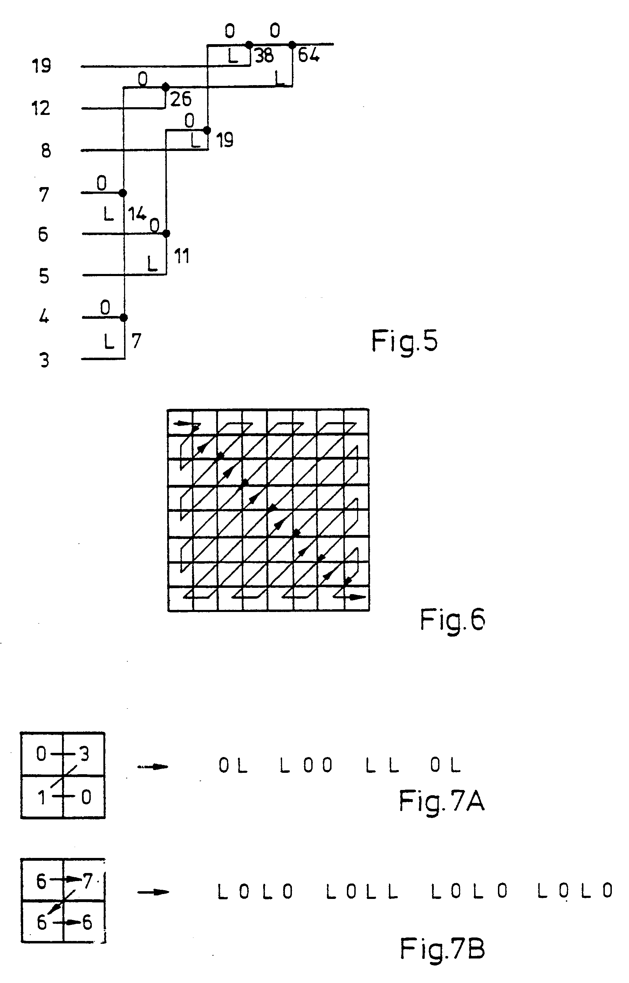

Fig. 5 zeigt das Berechnungsschema nach Huffman. Dabei werden die Häufigkeiten übereinander aufgetragen. Es wird von einem Baum- oder Verästelungsschema ausgegangen. Jeweils die niedrigsten Häufigkeiten werden in Zweierblocks zusammengefaßt und aufaddiert. Summen und/oder niedrigste Häufigkeiten werden weiterhin wieder in Zweierblocks zusammengefaßt. Die Zusammenfassung erfolgt so, daß die niedrigen Werte mit einem senkrechten Strich zu der Summe stoßen, die höheren Werte mit einem waagerechten Strich. Waagerechte Striche werden mit einer 0 bewertet, senkrechte Striche mit einer 1. Der Huffman-Kode wird auch erläutert auf den Seiten 52-55 in Robert C. Gallager, Information Theory and Reliable Communication, copyright 1968 by John Wiley & Sons, Inc. ISBN W-471-29048-3.

Fig. 6 zeigt einen Zick-Zack-Scan gemäß der EP-A- 00 84 270. Der Scan zeigt die Reihenfolge der zu übertragenden Werte an.

Fig. 7A zeigt Werte 0 3 1 0, die gemäß Huffman-Kode und Zick-Zack-Scan zu übertragen sind. Dabei ergibt sich die Binärfolge 0 1 1 0 0 1 1 0 1.

Fig. 7B zeigt Werte 6 7 6 6, die gemäß Zick-Zack-Scan und Huffman-Kode zu übertragen sind. Dabei ergibt sich die Binärfolge 1 0 1 0 1 0 1 1 1 0 1 0 1 0 1 0. Die Binärfolge zu den Werten 6 7 6 6 weist gegenüber der Binärfolge 0 3 1 0 mehr zu übertragende Binärzeichen auf. Wird die Häufigkeit der zu übertragende Werte in regelmäßigen Zeitabständen überprüft, so kann die Häufigkeit verschieden sein und ein neuer Huffman-Kode erstellt werden.

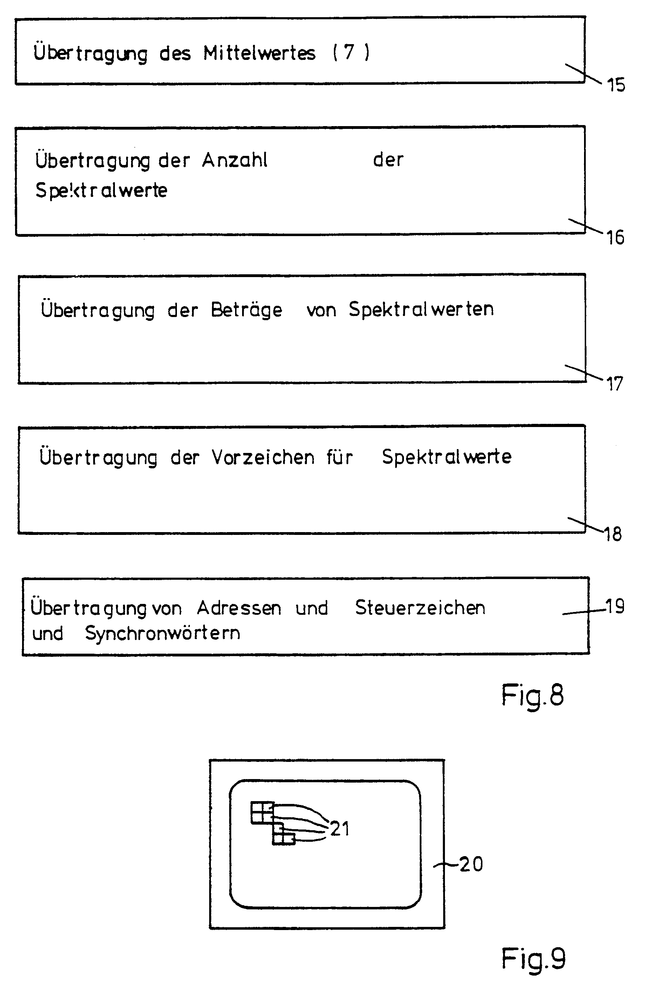

Fig. 8 zeigt Mengen 15-19, in denen zu übertragende Informationen aufgelistet sind. Übertragen wird der Mittelwert, die Anzahl der Spektralwerte, die Beträge der Spektralwerte, die Übertragung der Vorzeichen für Spektralwerte und Adressen, Steuerzeichen und Synchronwörter. Vorteilhaft wird die Reihenfolge der zu übertragenden Mengen wie folgt festgelegt : 19, 15, 16, 17, 18.

Fig. 9 zeigt ein Fernsehgerät 20 mit Zeitbereichsblöcken 21, die jeweils 64 Bildpunkte beinhalten. Die Zeitbereichsblöcke 21 werden blockweise in den Spektralbereich transformiert. Das geschieht z.B. mit der ADCT.

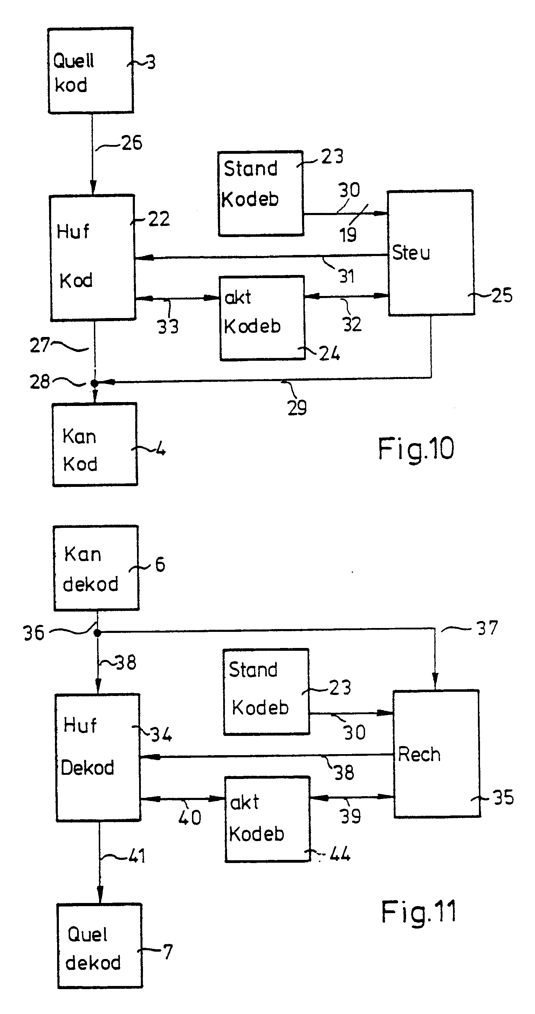

Fig. 10 zeigt die Reduzierung von zu übertragenden Werten mit Hilfe des adaptiven Huffman-Koders. Dazu wird zwischen einem Quellenkoder 3 und einem Kanalkoder 4 ein Huffman-Koder 22 zwischengeschaltet. Im aktuellen Kodebuch 24 sind die Zuordnungen zwischen Werten und dem Huffman-Kode abgespeichert. Beim Auftreten eines Wertes im Huffman-Koder 22, der über die Steuerleitung 26 vom Quellenkoder 3 kommt, wird über die Steuerleitung 33 der Huffman-Kode für den Wert abgerufen. Am Anfang einer Übertragung wird über die Steuerung 25 das aktuelle Kodebuch mit dem Standard-Kodebuch geladen. Zwischen Standard-Kodebuch 23 und Steuerung 25 ist die Leitung 30 angeordnet. Zwischen Steuerung 25 und aktuellem Kodebuch 24 liegt die bidirektionale Leitung 32. Wird das aktuelle Kodebuch 24 den Werten angepaßt, so tritt eine Änderung zwischen aktuellem Kodebuch und Standard-Kodebuch 23 auf. Die Steuerung 25 überprüft die Änderungen zwischen aktuellem Kodebuch 24 und Standard-Kodebuch 23 und teilt diese Änderung dem Kanalkoder 4 über die Leitung 29 mit. Dazu wird über die Leitung 31 der Huffman-Koder 22 so lange ausgeschaltet. Vorteilhaft geht dieser Änderungsmitteilung ein Synchronisatiorswort, im folgenden Synchronwort genannt, voran. Vom Kanalkoder 4 kann das Signal auf das Magnetband eines Videorecorders aufgezeichnet sein, oder das Signal wird über eine HF-Übertragungsstrecke übertragen. Beim Einschalten des Senders wird das aktuelle Kodebuch mit den Zuordnungen des Standard Codebuches 23 geladen. Die Steuerung fragt das Standard Kodebuch ab und lädt die Zuordnungen über die bidirektionale Leitung 32 in das aktuelle Kodebuch. Der Huffman-Koder 22 gibt die Huffman-kodierten Werte über eine Leitung 27 und den Knotenpunkt 28 an den Kanalkoder 4. Änderungsmitteilungen sind aufgrund eines bisherigen Kodebuches 24 und eines neuen aktuellen Kodebuches 44 möglich. Vorteilhaft werden Änderungsmitteilungen nur auf das Standard-Kodebuch 23 bezogen.

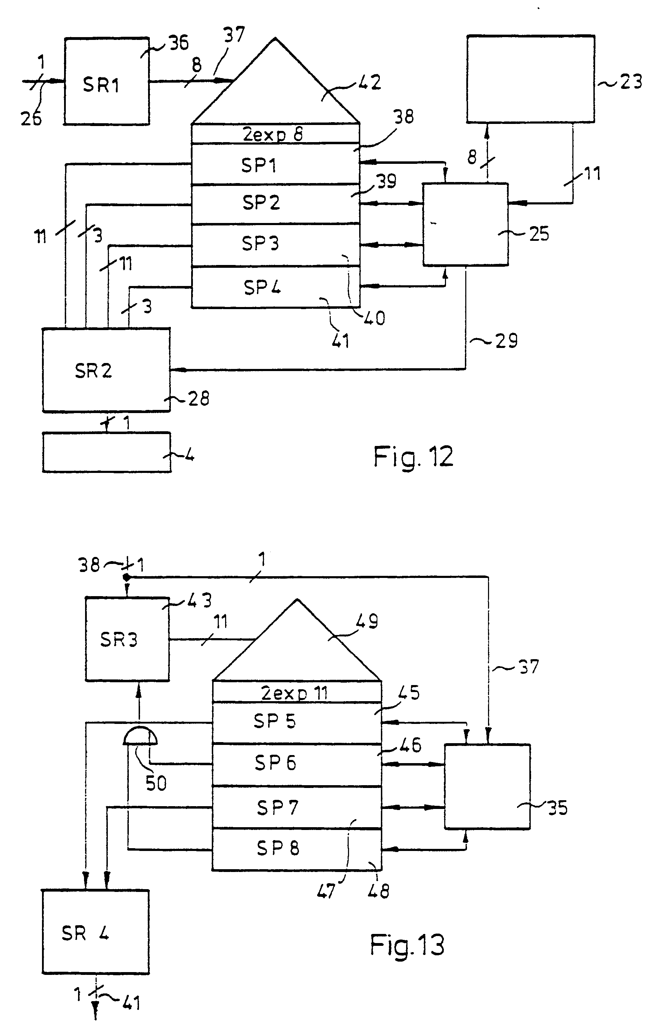

Fig. 11 zeigt einen Kanaldekoder 6, der ein Signal vom Magnetkopf eines videorecorders oder von einer HF-Übertragungsstrecke empfängt. Die Signale werden dekodiert und erreichen über die Leitungen 36,37 und 38 den Rechner 35 und den Huffman-Dekoder 34. Beim Einschalten des Empfängers lädt der Rechner 35 das aktuelle Kodebuch 44 über die bidirektionale Leitung 39 mit einer Standard Kodierungsvorschrift aus dem Standard-Kodebuch 23. Die Standard Kodierungsvorschrift ist definiert und für Empfänger und Sender gleichlautend. Zwischen Standard-Kodebuch 23 und Rechner 35 liegt die Leitung 30. Der Huffman-Dekoder 34 fragt beim Eintreffen von Signalen über die Leitung 38 das aktuelle Kodebuch 44 über die bidirektionale Leitung 40 ab und ordnet dem eintreffenden Huffman-Kode die Werte zu. Werte werden über die Leitung 41 an den Quellendekoder 7 weitergegeben. Erkennt der Rechner über die Leitung 37 Steuerzeichen, so wird der Huffman-Dekoder 34 über die Leitung 38 ausgeschaltet und das aktuelle Kodebuch 44 aufgrund der Synchronwörter, Steuerzeichen und Änderungsmitteilungen auf den aktuellen Stand gebracht.

Fig. 12 zeigt einen Huffman-Koder. Über die Leitung 26 wird ein Schieberegister 36 mit Werten geladen. Diese Werte weisen eine Länge von 8 Bit auf. Die 8 Bit werden als Adresse verwendet und steuern über einen Adressenbus 37 eine Adressendekodierung 42 an. Mit Hilfe von acht Adressen können 256 Speicherplätze, das sind 2 exp 8, angesprochen werden. Im Speicher 38 steht der Huffman-Kode. Im Speicher 38 ist eine maximale Kodewortlänge von 11 Bit speicherbar. Über den Speicher 39 wird die Kodewortlänge abgerufen. Die Kodewortlänge wird mit Hilfe einer 3 Bitleitung kodiert. Die Speicher 40 und 41 entsprechen den Speichern 38 und 39. Es sind zwei Speichereinheiten SP1, SP2 und SP3, SP4 notwendig, um das aktuelle Kodebuch 24 zu aktualisieren. In der Steuerung 25 wird die Anzahl von Werten gleicher Größe über einen vorgegebenen Zeitraum gezählt. Gemäß der Anzahl der Werte kann eine Aktualisierung erfolgen. Steht das bisherige aktuelle Kodebuch in den Speichern 38, 39, so wird das neue aktuelle Kodebuch in die Speicher 40 und 41 geschrieben. Nach einer Aktualisierung wird im Schieberegister 28 über die Steuerleitung 29 von der Steuerung 25 der aktuelle Stand mitgeteilt. Dazu werden die Eingänge an dem Schieberegister 28 der Leitungen zwischen dem Schieberegister 28 und den Speichern 38-41 gesperrt. Das Schieberegister 28 gibt während der Abschaltung Synchronwörter und die Aktualisierung an den Kanalkoder 4 weiter. Die Speicher 38-41 und die Adressendekodierung 42 entsprechen dem aktuellen Kodebuch 24 und können z.B. durch vier RAM TMS 4416-15 gebildet sein. Das Standard Kodebuch kann z.B. durch zwei EPROM TMS 2516 gebildet sein. Über 8 Adressen werden 11 zugehörige Werte abgerufen. Siehe dazu Texas Instruments, MOS Memory Data Book, 1984 – European Edition. Vorteilhaft wird erstens eine Anpassung des Huffman-Kodes im aktuellen Kodebuch 24 aufgrund einer Schwellwertentscheidung durchgeführt, zweitens über einen Zeitraum von zwei Fernsehbildern die Anzahl von Werten aufaddiert und nach einem Zeitraum von zwei Fernsehbildern eine Anpassung vorgenommen oder drittens eine Kombination beider Anpassungen durchgeführt. Bei der Schwellwertentscheidung werden die Anzahl der Werte aufaddiert und bei Überschreitung einer vorgegebenen Grenze die Anpassung ausgelöst.

Fig. 13 zeigt einen Huffman-Dekoder. Über die Leitung 37 erkennt der Rechner 35 Synchronwörter und damit eine Änderung des aktuellen Kodebuches. Huffman-kodierte Signale werden über die Leitung 38 auf das Schieberegister 43 gegeben. Im Schieberegister 43 kann nach der Huffman-Kodierung eine Länge von 11 Bit auftreten. Die Huffman-Kodierung von 11 Bit entspricht einem Adressenraum von 256 Bit, das sind 2 exp 8. Die Adressendekodierung 49 weist einen Adressenraum von 2 exp 11, das sind 2048, Bit auf. Von diesen Adressen dienen 256 der Huffman-Dekodierung. Die restlichen Speicherstellen zeigen an, daß kein gültiges Huffman-Kodewort im Schieberegister vorliegt. Die Speicher 45 und 46 entsprechen den Speichern 47 und 48. Das Schieberegister 43 wird bitweise geladen. Die Speicher 45-48 und die Adressendekodierung 49 entsprechen dem aktuellen Kodebuch 44. In dem Schieberegister 43 sind alle Bits zu null gesetzt. Beim Eintreffen der Huffman-kodierten Werte über die Leitung 38 werden die Bits im Schieberegister 43 seriell verschoben. Jeweils nach Eintreffen eines Bits wird in der Adressendekodierung 49 überprüft, ob unter dem im Schieberegister stehenden Wert eine Adressenzuordnung möglich ist. Dabei können 2, 3, 4, ... oder 11 Bits im Schieberegister 43 angekommen sein. Wird eine Huffman-Kodierung erkannt, so wird der zugehörige Wert vom Speicher 45 an das Schieberegister 4 weitergegeben. Gleichzeitig wird vom Speicher 46 aus über das ODER-Glied 50 das Schieberegister 3 auf den Anfangszustand zurückgesetzt, d.h. sämtliche Bitstellen mit Null geladen.

## Ansprüche

1. Verfahren zur digitalen Nachrichtenübertragung, insbesondere für aus analogen Signalen gewonnene digitale Videosignale, bei dem Gruppen (Fig. 3A) von Daten von einem Quellenkoder (3) verarbeitet und von einem Kanalkoder (4) auf einen Übertragungskanal (5) und von dem Übertragungskanal (5) über einen Kanaldekoder (6) zum Quellendekoder (7) gelangen, wobei für die zu überprüfenden Daten eine Kodierungsvorschrift mit variabler Kodewortlänge verwendet wird, in der häufig auftretenden Daten kurze und selten auftretenden Daten längere Kodewörter zugewiesen werden und die Kodierungsvorschrift ausgehend von einer Standardkodierungsvorschrift in Zeitabständen einer Statistik der Analog- und/oder Digitalsignale angepaßt wird, dadurch gekennzeichnet, daß zu Beginn einer Übertragung erst die fest gespeicherte Standardkodierungsvorschrift in einen Speicher für die aktuelle Kodierungsvorschrift übernommen und angewendet wird und daß diese Kodierungsvorschrift nachfolgend durch nicht fest gespeicherte, sondern individuell aus der Anzahl von Werten gleicher Größe über einen vorgegebenen Zeitraum ermittelte Kodierungsvorschriften ersetzt wird.

2. Verfahren nach Anspruch 1, dadurch gekennzeichnet daß die zu übertragungden Daten, für die die Kodierungsvorschrift verwendet wird, Adressen und-/oder Werte sind.

3. Verfahren nach Anspruch 1 oder 2, dadurch gekennzeichnet, daß die Kodierungsvorschrift in regelmäßigen Zeitabständen angepaßt ist.

4. Verfahren nach Anspruch 1 oder 2, dadurch gekennzeichnet, daß die Kodierungsvorschrift nach einer Schwellwertentscheidung angepaßt ist.

5. Verfahren nach Anspruch 1 oder 2, dadurch gekennzeichnet, daß die Kodierungsvorschrift in regelmäßigen Zeitabständen aufgrund einer Schwellwertentscheidung angepaßt ist.

6. Verfahren nach einem oder mehreren der Ansprüche 1-5, dadurch gekennzeichnet, daß eine Kodierungsvorschrift als Standard-Kodierungsvorschrift für einen Sender und einen Empfänger definiert ist.

7. Verfahren nach einem oder mehreren der Ansprüche 1-6, dadurch gekennzeichnet, daß die Kodierungsvorschrift der absoluten Auftretenswahrscheinlichkeit der vorangegangenen Daten angepaßt wird.

8. Verfahren nach Anspruch 7, dadurch gekennzeichnet, daß die Kodierungsvorschrift ausschließlich der absoluten Auftretenswahrscheinlichkeit der vorangegangenen Daten angepaßt wird.

9. Verfahren nach einem oder mehreren der Ansprüche 1-8, dadurch gekennzeichnet, daß Änderungen zwischen definierter und angepaßter Kodierungsvorschrift übertragen werden.

10. Verfahren nach einem oder mehreren der Ansprüche 1-9, dadurch gekennzeichnet, daß Änderungen zwischen zwei angepaßten Kodierungsvorschriften übertragen werden.

11. Verfahren nach einem oder mehreren der Ansprüche 1-10, dadurch gekennzeichnet, daß die Kodierungsvorschrift ein Huffman-Kode ist.

12. Verfahren nach einem oder mehreren der Ansprüche 1-11, dadurch gekennzeichnet, daß die Schaltung des Koders (22) im Sender (Fig. 12) ein RAM aufweist.

13. Verfahren nach einem oder mehreren der Ansprüche 1-11, dadurch gekennzeichnet, daß die die Schaltung Dekoders (34) im Empfänger (Fig. 13) ein RAM aufweist.


## Claims

1. A method for digital transmission of information, more particularly for digital video signals obtained from analogue signals, in which groups (Fig. 3A) of data are processed by a source coder (3) and arrive from a channel coder (4) on a transmission channel (5) and from the transmission channel (5) via a channel decoder (6) to the source decoder (7), in which a coding specification with variable code word length is used for the data to be checked, in which data which frequently occurs is allocated short code words and rarely occurring data is allocated fairly long code words and the coding specification is matched to statistics of the analogue and/or digital signals based on a standard coding specification in time spacings **characterised in that** at the beginning of a transmission only the firmly stored standard coding specification is taken into a memory as the current coding specification and is used and that this coding specification is then replaced by coding specifications which are not firmly stored but are ascertained individually from the plurality of values of the same size over a predetermined period of time.

2. A method according to claim 1, **characterised in that** the data to be transmitted, for which the coding specification is used, are addresses and/or values.

3. A method according to claim 1 or 2, **characterised in that** the coding specification is adjusted at regular time spacings.

4. A method according to claim 1 or 2, **characterised in that** the coding specification is adjusted according to a threshold value decision.

5. A method according to claim 1 or 2, **characterised in that** the coding specification is adjusted in regular time spacings based on a threshold value decision.

6. A. method according to one or more of claims 1 to 5, **characterised in that** a coding specification is defined as the standard coding specification for a transmitter and a receiver.

7. A method according to one or more of claims 1 to 6 **characterised in that** the coding specification is adapted to the absolute likelihood of the preceding data occurring.

8. A method according to claim 7, **characterised in that** the coding specification is adapted exclusively to the absolute likelihood of the preceding data occurring.

9. A method according to one or more of claims 1 to 8, **characterised in that** changes between defined and adjusted coding specification are transmitted.

10. A method according to one or more of claims 1 to 9, **characterised in that** changes between two adapted coding specifications are transmitted.

11. A method according to one or more of claims 1 to 10, **characterised in that** the coding specification is a Huffman code.

12. A method according to one or more of claims 1 to 11, **characterised in that** the circuit of the coder (22) has a RAM in the transmitter (Fig. 12).

13. A method according to one or more of claims 1 to 11, **characterised in that** the circuit of the decoder (34) has a RAM in the receiver (Fig. 13).


## Revendications

1. Procédé de transmission numérique d'informations, en particulier pour des signaux vidéo numériques extraits de signaux analogiques, dans lequel des groupes (fig. 3A) de données sont traités par un codeur de sources (3) et, provenant d'un codeur de canal (4), parviennent à un canal de transmission (5) et, provenant du canal de transmission (5), au décodeur de sources (7) en passant par un décodeur de canal (6), une prescription de codage avec une longueur de mot de code variable étant utilisée pour les données à vérifier, prescription dans laquelle des mots de code courts sont attribués aux données qui apparaissent fréquemment et des mots de code plus longs aux données qui apparaissent rarement et la prescription de codage étant adaptée, en partant d'une prescription de codage standard, à certains intervalles de temps à une statistique des signaux analogiques et/ou numériques, caractérisé en ce qu'au début d'une transmission tout d'abord la prescription de codage standard mémorisée de manière fixe est adoptée et utilisée dans une mémoire pour la prescription actuelle de codage et que cette prescription de codage est ensuite remplacée par des prescriptions de codage qui ne sont pas mémorisées de manière fixe mais au contraire qui sont déterminées de manière individuelle à partir du nombre de valeurs de même importance pendant une période prédéterminée.

2. Procédé selon la revendication 1, caractérisé en ce que les données à transmettre, pour lesquelles la prescription de codage est utilisée, sont des adresses et/ou des valeurs.

3. Procédé selon la revendication 1 ou 2, caractérisé en ce que la prescription de codage est adaptée à des intervalles réguliers.

4. Procédé selon la revendication 1 ou 2, caractérisé en ce que la prescription de codage est adaptée après une décision de seuil.

5. Procédé selon la revendication 1 ou 2, caractérisé en ce que la prescription de codage est adaptée à intervalles réguliers en raison d'une décision de seuil.

6. Procédé selon l'une ou plusieurs des revendications 1 à 5, caractérisé en ce qu'une prescription de codage est définie comme prescription de codage standard pour un émetteur et un récepteur.

7. Procédé selon l'une ou plusieurs des revendications 1 à 6, caractérisé en ce que la prescription de codage est adaptée à la probabilité d'apparition absolue des données précédentes.

8. Procédé selon la revendication 7, caractérisé en ce que la prescription de codage est exclusivement adaptée à la probabilité d'apparition absolue des données précédentes.

9. Procédé selon l'une ou plusieurs des revendications 1 à 9, caractérisé en ce que des modifications entre la prescription de codage définie et la prescription de codage adaptée sont transmises.

10. Procédé selon l'une ou plusieurs des revendications 1 à 9, caractérisé en ce que des modifications entre deux prescriptions de codage adaptées sont transmises.

11. Procédé selon l'une ou plusieurs des revendications 1 à 10, caractérisé en ce que la prescription de codage est un code selon Huffman.

12. Procédé selon l'une ou plusieurs des revendications 1 à 11, caractérisé en ce que le circuit du codeur (229 dans l'émetteur (fig. 12) présente une mémoire vive.

13. Procédé selon l'une ou plusieurs des revendications 1 à 11, caractérisé en ce que le circuit du décodeur (34) dans le récepteur (fig. 13) présente une mémoire vive.

Fig.1

Fig.2

| X | 7 | 0 | 0 | 0 | 6 | 5 | 5 |
| 7 | 4 | 4 | 3 | 3 | 5 | 4 | 4 |
| 6 | 4 | 2 | 2 | 4 | 3 | 3 | 3 |
| 6 | 5 | 1 | 1 | 1 | 0 | 2 | 2 |
| 6 | 3 | 1 | 0 | 0 | 0 | 0 | 0 |
| 5 | 1 | 2 | 0 | 1 | 1 | 1 | 0 |
| 1 | 2 | 2 | 1 | 0 | 0 | 0 | 0 |
| 1 | 3 | 1 | 2 | 0 | 0 | 0 | 0 |

Fig.3

| Werte | Binär-Code | Häufigkeit | Huffman-Code |
|-------|------------|------------|--------------|
| 0 | 0 0 0 | 1 9 | 0 L |
| 1 | 0 0 1 | 1 2 | L L |
| 2 | 0 1 0 | 8 | 0 0 L |
| 3 | 0 1 1 | 7 | L 0 0 |
| 4 | 1 0 0 | 6 | 0 0 0 0 |
| 5 | 1 0 1 | 5 | 0 0 0 L |
| 6 | 1 1 0 | 4 | L 0 L 0 |
| 7 | 1 1 1 | 3 | L 0 L L |

Fig.4

Fig.5

Fig.6

OL  L 0 0  L L  0 L

Fig.7A

L 0 L 0  L 0 L L  L 0 L 0  L 0 L 0

Fig.7B

Übertragung des Mittelwertes ( 7 )

— 15

Übertragung der Anzahl der
Spektralwerte

— 16

Übertragung der Beträge von Spektralwerten

— 17

Übertragung der Vorzeichen für Spektralwerte

— 18

Übertragung von Adressen und Steuerzeichen
und Synchronwörtern

— 19

**Fig.8**

— 21

— 20

**Fig.9**

Fig.10

Fig.11

Fig. 12

Fig. 13